# EUROPÄISCHE PATENTANMELDUNG

(11) **EP 1 647 763 A1**
(43) Veröffentlichungstag der Anmeldung: **19.04.2006**
(21) Anmeldenummer: 04024240.6
(22) Anmeldetag: 12.10.2004
(51) Int. Cl.: F21S 8/00, H01L 33/00, H05K 1/02, F21K 7/00

(54) **Operations- und Untersuchungsleuchte mit optimierter LED-Lichtquelle**

(71) Anmelder: Scanatron Technics AG, 8910 Affoltern am Albis (CH)
(72) Erfinder: Weibel, Reto, 8909 Zwillikon (CH)

(57) **Zusammenfassung**

Die erfindungsgemässe Operations- und Untersuchungsleuchte besteht aus mindestens einem Gehäuse zum Halten von mindestens einer LED-Lichtquelle. Die Lichtquelle besteht aus mindestens einer Leuchtdiode (1,6,8), mindestens einem LED-Träger mit integrierter Verdrahtung (2,7,9), mindestens einer Optik (3) sowie einem oder mehreren optionalen Farbkorrekturfilter (5). Die Farbtemperatur, die spektralen Eigenschaften und die Lichtleistung der LED-Lichtquelle werden durch den Einsatz mindestens einer Leuchtdiode (LED) mit entsprechenden spektralen und optischen Eigenschaften oder durch den Einsatz von mehreren Leuchtdioden (LED) mit unterschiedlichen spektralen und optischen Eigenschaften optimiert.

Verbesserte Wärmeableitung, bestehend aus einem oder mehreren nichtleitenden Träger (9) für die Befestigung von Komponenten, mit einseitiger oder beidseitiger Kupferkaschierung oder Metallisierung (11), mit mindestens einer durchgehenden Bohrung (10), eine oder mehrere Bohrungen sind metallisiert (11). Der Träger kann optional auf einen oder mehrere Kühlkörper (4,12) montiert werden.

Der Erfindung liegt die Aufgabe zu Grunde, ein Gehäuse zum Halten mindestens einer elektrischen Lichtquelle zu schaffen, das die Nachteile der bekannten Lichtsysteme von Operations- und Untersuchungsleuchten vermeidet und möglichst betriebssicher, vielseitig, kompakt und leicht ist.

Die erfindungsgemässe Operations- und Untersuchungsleuchte weist die Vorteile auf, dass die Farbwiedergabe verbessert wird, keine Wärmestrahlung im Arbeits- oder Operationsbereich entsteht, die Leuchtmittel eine sehr lange Lebensdauer aufweisen, die ganze Leuchte leichter und kompakter wird.

## Beschreibung

Die Erfindung betrifft eine Operations- und Untersuchungsleuchte gemäss dem Oberbegriff von Anspruch 1, also mindestens einem Gehäuse zum Halten von mindestens einer LED-Lichtquelle mit verbesserter Wärmeableitung. Die Operations- und Untersuchungsleuchte kann beispielsweise an Trag- oder Schwenkarme oder auf Stative montiert werden, beispielsweise um Arbeitsplätze oder Operationsfelder auszuleuchten. Es können mehrere dieser Leuchten nebeneinander oder übereinander angebracht werden.

Bekannte Operations- und Untersuchungsleuchten verwenden Glüh- oder Halogenlampen, in neuerer Zeit auch Hochdruck- und Entladungslampen, als Lichtquelle. Das Licht wird über einen oder mehrere Reflektoren auf den Arbeitsplatz bzw. auf das Operationsfeld gelenkt.
Diese bekannten Leuchten haben den Nachteil, dass die eingesetzten Leuchtmittel eine grosse Wärme entwickeln und auch abstrahlen. Die relativ kurze Lebensdauer dieser Leuchtmittel generiert einen grossen Aufwand für Wartung und Unterhalt. Aufgrund der punktförmigen Lichterzeugung und hohen Betriebstemperaturen werden hohe Anforderungen an die Reflektoren und Gehäuse gestellt.
Vor allem hochwertige Reflektoren sind meist aus Glas hergestellt und werden bedampft, so dass die vorhandene Wärme möglichst nicht reflektiert wird. Solche Glasreflektoren haben ein hohes Eigengewicht, sind zerbrechlich und die Herstellung ist teuer. Bei den günstigeren Metallreflektoren werden den Lichtquellen meistens nur Wärmefilter vorgelegt, was ohne zusätzliche, aufwendige Wärmeabführung zu einer Verkürzung der Lebensdauer vom Leuchtmittel führt.
Ähnliche Probleme ergeben sich auch durch die Filterung zur Anpassung der Farbtemperatur und Farbwiedergabe. Zusätzlich reduziert jede Filterung den Wirkungsgrad der Lichtquelle, teilweise sogar massiv.
Wechselstrombetriebene Entladungslampen erzeugen ein unmerklich gepulstes Licht. Dies führt zum einen zu einer schnellen Ermüdung der Augen. Zum anderen entstehen zusammen mit dem Raumlicht und Bildschirmen Interferenzen, welche die Arbeitsqualität einschränken und zusätzlich zu Ermüdung führen. Hochdruck- und Entladungslampen benötigen vielfach eine hohe Betriebsspannung, ebenso eine Aufwärmzeit von mehreren Minuten bis zur vollen Lichtabgabe.

Der Erfindung liegt daher die Aufgabe zu Grunde, mindestens ein Gehäuse zum Halten von mindestens einer elektrischen Lichtquelle zu schaffen, das die Nachteile der bekannten Lichtsysteme von Operations- und Untersuchungsleuchten vermeidet und möglichst betriebssicher, vielseitig, kompakt und leicht ist.
Diese Aufgabe wird erfindungsgemäss durch eine Operations- und Untersuchungsleuchte mit den Merkmalen des Anspruchs 1 gelöst.
Die Erfindung betrifft ferner eine Lichtquelle, die erfindungsgemäss die Merkmale von Anspruch 2 aufweist.
Vorteilhafte Weiterbildungen des Gehäuses und der Lichtquelle gehen aus den abhängigen Ansprüchen hervor.

Die Operations- und Untersuchungsleuchte weist gemäss der Erfindung mindestens ein rundes oder sternförmiges Gehäuse auf, in welchem mindestens eine Halterung für mindestens eine LED-Lichtquelle sowie die zum Betrieb notwendigen elektrischen Geräte und Verdrahtung untergebracht sind.
Für die Lichtquelle wird mindestens eine Leuchtdiode (LED) zur Lichterzeugung eingesetzt. Leuchtdioden übertreffen herkömmliche Leuchtmittel durch eine gute Lichtleistung, geringe Erwärmung, keine Wärmestrahlung, niedrige Betriebsspannung, sehr lange Lebensdauer und geringes Eigengewicht.
Das abgegebene Licht von einer oder mehreren Leuchtdioden (LED) wird durch mindestens eine Optik gebündelt und beispielsweise auf ein Operationsfeld geworfen. Bedingt durch die günstigen Eigenschaften von Leuchtdioden lässt sich eine einfachere und kostengünstigere Optik, beispielsweise aus Kunststoff, einsetzen.
Die Wärme, erzeugt durch die Verlustleistung der Leuchtdioden, wird durch mindestens einen LED-Träger mit mindestens einer Bohrung, wovon mindestens eine metallisiert ist, abgeführt. Dies reduziert den Aufwand zur Kühlung der Leuchtdioden bzw. der Lichtquelle erheblich.

Auf jedem Gehäuse der erfindungsgemässen Operations- und Untersuchungsleuchte ist eine Kabeldurchführung für die Versorgungsleitung angebracht. Im Weiteren sind alle stromführenden Teile durch das bzw. die Gehäuse abgedeckt. Das bzw. die Gehäuse wird oder werden über mindestens eine feste oder mindestens eine bewegliche Verbindung auf einem Träger befestigt. Jede Gehäusefrontseite weist vor jeder Lichtquellenhalterung eine runde Öffnung auf, durch welche das Licht austritt.
Jede Halterung für LED-Lichtquellen besteht aus mindestens einem ringförmigen Element, in welches mindestens eine Lichtquelle eingeführt und befestigt wird. Mindestens ein ringförmiges Element ist mit dem dazugehörigen Gehäuse fest verbunden. In jede Lichtaustrittsöffnung von jedem Gehäuse kann mindestens ein Halter für mindestens einen optionalen Farbkorrekturfilter angebracht werden.

Der Erfindungsgegenstand und weitere Vorteile von diesem werden anschliessend anhand von in den Zeichnungen dargestellten Ausführungsbeispielen erläutert. In den Zeichnungen zeigen:

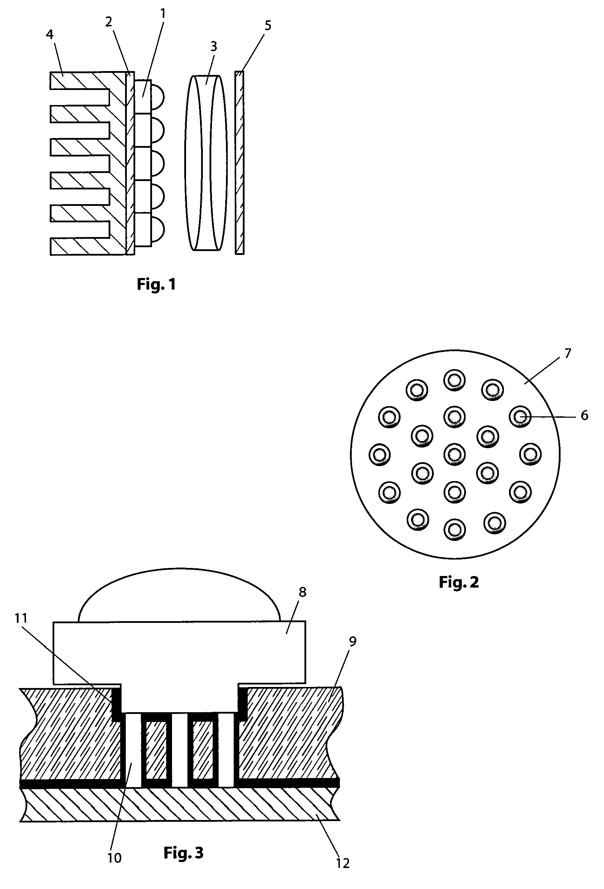

- Fig. 1: eine schematische Darstellung der optimierten LED-Lichtquelle in Seitenansicht;
- Fig. 2: eine schematische Darstellung über die Anordnung der Leuchtdioden (LED) auf einem LED-Träger, wobei die gezeigte Anzahl nicht massgebend ist;
- Fig. 3: ein schematischer Querschnitt von der verbesserten Wärmeableitung.

Die erfindungsgemässe LED-Lichtquelle besteht im Wesentlichen aus mindestens einer Leuchtdiode (1,6,8), welche auf mindestens einem LED-Träger (2,7,9) befestigt wird. In jedem LED-Träger ist auch die Verdrahtung für die Versorgung mindestens einer Leuchtdiode integriert. Das abgegebene Licht von einer oder mehreren Leuchtdioden wird durch mindestens eine Optik (3) gebündelt, das heisst zu einem Lichtstrahl zusammengefasst. Die Optik kann aus Glas oder Kunststoff gefertigt sein. Jeder LED-Träger (2,7,9) kann auf einen oder mehrere optionale Kühlkörper (4,12) oder auch an ein Gehäuse montiert werden, um beispielsweise die Effizienz der Wärmeableitung noch weiter zu steigern. Durch Einsatz mindestens einer Leuchtdiode (1,6,8) mit entsprechenden spektralen und optischen Eigenschaften oder durch den gemischten Einsatz von mehreren Leuchtdioden (6) mit unterschiedlichen spektralen und optischen Eigenschaften werden Farbtemperatur und Lichtleistung optimiert, um eine der Anwendung entsprechende Beleuchtung zu erreichen. Zur Feinabstimmung der Lichteigenschaften kann der Lichtquelle ein oder mehrere Farbkorrekturfilter (5) vorgelegt werden. Die Lichtquelle wird hauptsächlich mit Gleichstrom gespeist. Es kann aber auch die Pulsbreitenmodulation (Grundfrequenz grösser 20kHz) zur Speisung eingesetzt werden.

Aufgrund der Verlustleistung erzeugen die Leuchtdioden (1,6,8) Wärme auf einer relativ kleinen Fläche. Diese Wärme muss abgeführt werden um eine thermische Überlastung der LED zu verhindern. Erfindungsgemäss sind die LED-Träger (2,7,9) für die Wärmeableitung optimiert. Die Leuchtdioden (8) werden dabei auf mindestens einem nichtleitenden Träger (9) befestigt. Diese Träger (9) weisen eine einseitige oder beidseitige Kupferkaschierung oder Metallisierung (11) auf. Im Bereich der LED (8) wird mindestens eine durchgehende Bohrung (10) gemacht. Mindestens eine Bohrung ist metallisiert (11). Die Metallisierung (11) weist eine gute Wärmeleitfähigkeit auf. Die Wärme verteilt sich über die ganze metallisierte Oberfläche(11) und kann in die Umgebung abfliessen. Die Effizienz der Wärmeableitung kann optional durch Montage der LED-Träger (2,7,9) auf einen oder mehrere Kühlkörper (4,12) gesteigert werden, wobei das Gehäuse der Lichtquelle auch als Kühlkörper dienen kann.

## Patentansprüche

1. **Operations- und Untersuchungsleuchte**
a) mit mindestens einem Gehäuse zum Halten von
b) mindestens einer LED-Lichtquelle mit den Merkmalen nach Anspruch 2.

2. **Optimierte LED-Lichtquelle**
a) bestehend aus mindestens einer Leuchtdiode [LED](1,6,8), mindestens einem LED-Träger mit integrierter Verdrahtung (2,7,9), mindestens einer Optik (3) sowie einem oder mehreren optionalen Farbkorrekturfilter (5),
b) mit optimierter Farbtemperatur und Lichtleistung sowie optimierten spektralen Eigenschaften durch den Einsatz mindestens einer Leuchtdiode (LED) mit entsprechenden spektralen und optischen Eigenschaften oder
c) durch den Einsatz von mehreren Leuchtdioden (LED) mit unterschiedlichen spektralen und optischen Eigenschaften (Fig. 2),
d) mit verbesserter Wärmeableitung mit den Merkmalen nach Anspruch 3.

3. **Optimierte LED-Lichtquelle mit verbesserte Wärmeableitung**
a) Optimierte LED-Lichtquelle mit den Merkmalen nach Anspruch 2,
b) mit mindestens einem nichtleitenden Träger (9) für die Aufnahme von Komponenten, mit einseitiger oder beidseitiger Kupferkaschierung oder Metallisierung (11),
c) mit mindestens einer durchgehenden Bohrung (10),
d) eine oder mehrere Bohrungen sind metallisiert (11),
e) kann optional auf einen oder mehrere Kühlkörper (4,12) montiert werden.
